# EUROPÄISCHE PATENTSCHRIFT

(11) **EP 2 411 766 B1**
(45) Veröffentlichungstag und Bekanntmachung des Hinweises auf die Patenterteilung: **06.05.2015**
(21) Anmeldenummer: 10709994.7
(22) Anmeldetag: 08.03.2010
(51) Int. Cl.: G01C 19/5712

(54) **MIKRO-GYROSKOP ZUR ERMITTLUNG VON ROTATIONSBEWEGUNGEN UM DREI SENKRECHT AUFEINANDERSTEHENDE RAUMACHSEN**
MICRO GYROSCOPE FOR DETERMINING ROTATIONAL MOVEMENTS ABOUT THREE SPATIAL AXES WHICH ARE PERPENDICULAR TO ONE ANOTHER
MICROGYROSCOPE POUR LA DÉTERMINATION DE MOUVEMENTS DE ROTATION AUTOUR DE TROIS AXES DANS L'ESPACE PERPENDICULAIRES ENTRE EUX

(30) Priorität: 26.03.2009 DE 102009001922
(43) Veröffentlichungstag der Anmeldung: 01.02.2012
(73) Patentinhaber: Maxim Integrated GmbH, 8403 Lebring (AT)
(72) Erfinder: HAMMER, Hanno, A-8403 Graz-Lebring (AT)
(74) Vertreter: Bergmeier, Werner
(86) Internationale Anmeldenummer: PCT/EP2010/052880
(87) Internationale Veröffentlichungsnummer: WO 2010/108773

(56) Entgegenhaltungen:
- EP-A1- 1 832 841

## Beschreibung

Die vorliegende Erfindung betrifft ein Mikro-Gyroskop zur Ermittlung von Rotationsbewegungen um drei senkrecht aufeinanderstehende Raumachsen x, y und z mit einem Substrat, auf welchem mehrere tangential um die senkrecht auf dem Substrat stehende z-Achse oszillierende Massen angeordnet sind, wobei die oszillierenden Massen mittels Federn und Ankern auf dem Substrat befestigt sind, mit Antriebselementen zur Aufrechterhaltung oszillierender tangentialer Schwingungen der Massen um die z-Achse, wodurch die Massen bei einer Rotation des Substrates um eine beliebige Raumachse Corioliskräften und dadurch verursachten Auslenkungen unterworfen sind und mit Sensorelementen, um die Auslenkungen der Massen aufgrund der erzeugten Corioliskräfte zu erfassen.

Mikro-Gyroskope werden in der Regel zur Ermittlung einer Drehbewegung um eine Achse in einem orthogonalen x-y-z-Koordinatensystem verwendet. Um Drehbewegungen des Systems um jede der drei Achsen ermitteln zu können, sind daher drei derartige Mikro-Gyroskope erforderlich. Dies ist kostenintensiv und aufwendig in der Steuerung bzw. Auswertung der Daten.

Aus der TWI286201 BB ist ein dreiachsiges mikro-elektro-mechanisches MEMS-Gyroskop bekannt. Hierbei werden Massen, welche an einem zentralen Anker angeordnet sind, in eine oszillierende Drehbewegung versetzt. Die Massen sind auf einem Substrat angeordnet und werden bei einer Drehung um die x- oder y-Achse aufgrund einer hierbei auftretenden Corioliskraft um die y- bzw. x-Achse gekippt. Dies wird ermöglicht durch eine entsprechende Aufhängung dieser Antriebsmassen an dem Substrat. Bei einer Drehung um die z-Achse sind Teilmassen durch wiederum eine entsprechende Aufhängung dieser Teilmassen an den drehbar gelagerten Massen translatorisch auslenkbar. Sowohl die Kippbewegungen als auch die translatorische Bewegung kann mittels Sensoren erfasst werden und dient aufgrund ihrer Proportionalität zu der Drehbewegung des Substrats als Maß für die entsprechende Drehung um die x-, y- oder z-Achse. Die jeweiligen Auslenkungen sind jedoch nur sehr schwierig zu ermitteln.

Die EP 1 832 841 offenbart ein weiteres dreiachsiges MEMS-Gyraskop mit den Merkmalen aus dem Oberbegriff des Anspruchs 1.

Um ein dreidimensionales Gyroskop schaffen zu können, bei welchem Drehungen um alle drei Achsen festgestellt werden können, hat D. Wood et al. in dem Artikel "A monolithic silicon gyroscope capable of sensing about three axes simultaneously" 1996 ein Gyroskop vorgeschlagen, welches ringförmig um einen zentralen Anker angeordnete oszillierende Massen aufweist. Diese Massen sind in der Lage, sowohl Kipp- als auch Drehbewegungen aufgrund auftretender Corioliskräfte durchführen zu können. Nachteilig ist hierbei, dass die Fertigung eines solchen Sensors ebenso wie der Antrieb der bewegten Massen schwierig ist. Die Bewegungen der einzelnen Bestandteile des Sensors beeinflussen sich gegenseitig, sodass Messungen der Bewegung in x-, y- oder z-Richtung des Gyroskops keine ausreichende Genauigkeit liefern.

Aufgabe der vorliegenden Erfindung ist es, ein Mikro-Gyroskop zur Ermittlung von Rotationsbewegungen um drei senkrecht aufeinanderstehende Raumachsen x, y und z zu schaffen, welches eine hohe Erfassungsgenauigkeit der Auslenkungen in den einzelnen Drehrichtungen aufweist und welches nicht durch Bewegungen in den anderen als den zu erfassenden Richtungen, insbesondere nicht durch den Antrieb der Massen, in ihrer Erfassung verfälscht wird.

Die Aufgabe wird gelöst mit einem Mikro-Gyroskop mit den Merkmalen des Anspruches 1.

Das erfindungsgemäße Mikro-Gyroskop dient zur Ermittlung von Rotationsbewegungen um drei senkrecht aufeinanderstehende Raumachsen x, y und z. Es weist ein Substrat auf, auf welchem mehrere tangential um die senkrecht auf dem Substrat stehende z-Achse oszillierende Massen angeordnet sind, wobei die oszillierenden Massen mittels Federn und Ankern auf dem Substrat befestigt sind. Antriebselemente treiben die Massen um die z-Achse an und halten eine oszillierende tangentiale Schwingung der Massen um die z-Achse aufrecht. Bei einer Rotation des Substrates um eine beliebige Raumachse treten Corioliskräfte auf und verursachen eine Auslenkung der angetriebenen Massen. Sensorelemente sind im Bereich der Massen angeordnet und erfassen die Auslenkungen der Massen, welche diese aufgrund der durch die Drehbewegung des Substrats erzeugten Corioliskräfte erfahren.

Erfindungsgemäß sind einige der um die z-Achse oszillierenden Massen im Wesentlichen um die parallel zum Substrat verlaufende x-Achse kippbar gelagert. Andere der um die z-Achse oszillierenden Massen sind im Wesentlichen um die ebenfalls parallel zum Substrat verlaufende y-Achse kippbar gelagert. Wenigstens eine andere der oszillierenden Massen ist zusätzlich im Wesentlichen radial zur z-Achse, in der x-y-Ebene parallel zur Ebene des Substrates, auslenkbar; solche Massen werden im folgenden als z-Massen bezeichnet. Dieser zusätzlich radial auslenkbaren z-Masse ist ein ebenfalls radial zu der z-Achse auslenkbares, aber nicht um die z-Achse oszillierendes Sensorelement zugeordnet.

Durch die erfindungsgemäße Trennung der z-Masse von dem Sensorelement kann in besonders vorteilhafter Weise eine Entkopplung der tangentialen Antriebsbewegung von der radialen Sensorbewegung erfolgen. Das Sensorelement selbst ist nicht tangential angetrieben, wodurch einzig die radiale Bewegung des Sensorelementes zu erfassen ist, um eine Drehbewegung des Substrates um die z-Achse festzustellen. Die z-Masse wird zusammen mit den anderen Massen um die z-Achse oszillierend bewegt und beim Auftreten einer Rotation des Substrats um die z-Achse durch die dadurch auftretende Corioliskraft in radialer Richtung ausgelenkt. Die z-Masse vollzieht dann sowohl eine tangentiale als auch eine radiale Bewegung, lediglich die radiale Bewegung wird allerdings auf das Sensorelement übertragen. Diese einzige Bewegungsrichtung des Sensorelementes in radialer Richtung kann sehr einfach und ohne Überlagerung mit anderen Bewegungen erfasst werden. Die Erfassungsgenauigkeit wird hierdurch gegenüber den Lösungen des Standes der Technik deutlich verbessert.

Gemäß einer vorteilhaften Ausbildung der Erfindung weist das Gyroskop im Wesentlichen acht Massen auf, welche tangential um die z-Achse oszillieren, wobei vier dieser Massen zusätzlich radial zur z-Achse beweglich, und somit als z-Massen bezeichnet sind. Durch die Anordnung von acht oszillierenden Massen, von denen vier z-Massen sind, wird ein hinsichtlich der auftretenden Kräfte ausgeglichenes Gyroskop geschaffen. Die Corioliskräfte können relativ einfach erfasst werden und es kann zuverlässig die entsprechende Ursache einer Drehbewegung um eine bestimmte Achse ermittelt werden. Insbesondere, wenn die acht Massen gleichmäßig am Umfang verteilt sind und die im Wesentlichen nur tangential um die z-Achse oszillierenden Massen entlang der x-Richtung und der y-Richtung ausgerichtet sind und die übrigen z-Massen zwischen den x- und y-Achsen angeordnet sind, wird ein besonders ausgeglichenes System erhalten. Wie alle an der Antriebsbewegung beteiligten Massen werden auch die z-Massen in tangentialer Richtung um die z-Achse angetrieben, können jedoch zusätzlich radial zur z-Achse ausgelenkt werden. Diese Massen werden vorzugsweise von halboffenen Rahmen gehalten und in die tangentiale Antriebsbewegung versetzt. Die Corioliskraft wirkt lediglich auf die Bewegbarkeit der z-Masse in radialer Richtung, wodurch wiederum das Sensorelement zur Ermittlung einer Drehrate um die z-Achse ausgelenkt wird.

In einer vorteilhaften Ausbildung der Erfindung sind die im Wesentlichen nur tangential um die z-Achse oszillierenden Massen Kipp-Platten zum Erfassen einer Drehung des Substrates um die x- bzw. y-Achse. Sobald eine Corioliskraft aufgrund einer Drehung des Substrates um die x- oder y-Achse auftritt, werden diese nur tangential um die z-Achse oszillierenden Massen um die y- bzw. x-Achse gekippt. Diese Kippbewegung kann mittels kapazitiver Sensoren, welche den Massen zugeordnet sind, in elektrische Signale umgewandelt werden.

Vorzugsweise ist die sowohl radial zur als auch tangential um die z-Achse bewegliche z-Masse an einen Rahmen gekoppelt, um in eine tangentiale Bewegung um die z-Achse versetzt werden zu können. Der Rahmen sorgt einerseits für den tangentialen Antrieb der z-Masse und andererseits für eine stabile Aufhängung der z-Masse, um eine Bewegung in radialer Richtung durchführen zu können. Durch die besondere Gestaltung des Rahmens kann die z-Masse hinreichend groß ausgeführt werden, um eine deutliche Reaktion auf die Corioliskräfte zu zeigen und in radialer Richtung ausgelenkt werden zu können. Aus dieser Gestaltungsvariante wird deutlich, dass die Haupteigenschaft der z-Masse im Wesentlichen die Auslenkung in radialer Richtung ist, welche andererseits nur auftreten kann, wenn die gesamte Kombination aus Rahmen und z-Masse in tangentialer Richtung als Primärbewegung angetrieben wird. Besonders wichtig ist hierbei jedoch die Sekundärbewegung in radialer Richtung. Durch die rahmenartige Gestaltung können diese Eigenschaften sehr vorteilhaft umgesetzt werden.

Ein vorteil der Erfindung ist, dass die sowohl radial zur als auch tangential um die z-Achse bewegliche z-Masse mit zumindest einem Sensorelement zum Erfassen ihrer durch Corioliskräfte hervorgerufenen radialen Auslenkung verbunden ist. Hierdurch müssen die Auslenkungen nicht an der z-Masse selbst, welche Bewegungen sowohl in radialer als auch in tangentialer Richtung durchführt, gemessen werden, sondern die auftretenden Corioliskräfte, welche zu einer radialen Auslenkung der z-Masse führen, können durch das lediglich in radialer Richtung bewegliche Sensorelement erfasst werden. Dies führt zu einer deutlichen Verbesserung der zu ermittelnden Messergebnisse, da es keine Überlagerungen mit anderen Bewegungen gibt. Eine Bewegung des Sensorelementes deutet ausschließlich auf eine Corioliskraft in radialer Richtung hin. Das hierdurch festgestellte Signal kann dadurch sehr einfach ausgewertet werden.

In einer vorteilhaften Ausführung der Erfindung ist der Rahmen mit Federn, insbesondere mit zwei Federn, tangential um die z-Achse beweglich auf dem Substrat verankert. In anderen als in einer Tangentialrichtung ist der Rahmen weitgehend unbeweglich. Der Rahmen ist hierdurch nur in der Lage, eine Oszillationsbewegung in tangentialer Richtung durchzuführen. Corioliskräfte, welche auf den Rahmen wirken, können keine radiale Auslenkung des Rahmens bewirken. In der radialen Richtung ist der Rahmen bzw. sind die Federn dementsprechend steif ausgebildet. Auch in einer Bewegung aus der x-y-Ebene heraus bewegt sich der Rahmen vorzugsweise nicht, so dass er auch bzgl. Drehraten um die x-Achse oder um die y-Achse nicht auf die dadurch entstehenden Corioliskräfte reagiert. Die Steifigkeit in dieser Richtung ist aber nicht in jedem Falle erforderlich. Es kann auch toleriert werden, dass sich der Rahmen und die z-Masse aus der x-y-Ebene heraus bewegt, wenn sichergestellt ist, dass sich diese Bewegung nicht auf das Sensorelement überträgt und dessen Messung beeinflusst.

Um ein bzgl. der zwischen den bewegten Massen herrschenden Reaktionskräfte und -momente möglichst ausgeglichenes System eines Mikro-Gyroskops zu erhalten, ist vorzugsweise vorgesehen, dass die Rahmen zwischen den tangential um die z-Achse oszillierenden Massen bzw. Kipp-Platten angeordnet sind.

Die z-Massen, welche sowohl radial zur als auch tangential um die z-Achse beweglich sind, sind mit dem jeweiligen Rahmen mit mindestens einer Feder, vorzugsweise vier Federn verbunden. Damit erfolgt eine stabile Lagerung der z-Masse innerhalb des Rahmens, wodurch vorteilhafterweise sichergestellt ist, dass die z-Masse nur in radialer Bewegung relativ zum Rahmen bewegbar ist. Die z-Masse reagiert dabei lediglich auf Drehraten um die z-Achse, wodurch eine eindeutige Reaktion des der z-Masse zugeordneten Sensorelements und ein entsprechend eindeutiges Messergebnis aufgrund des daraus resultierenden elektrischen Signals gewährleistet werden kann.

Sind in einer vorteilhaften Ausführung der Erfindung die Rahmen im Wesentlichen nur tangential um die z-Achse beweglich auf dem Substrat verankert, so ist die Primärbewegung in die Rahmen eindeutig als Rotation in tangentialer Richtung um die z-Achse in den Rahmen einleitbar. Als Sekundärbewegung ergibt sich dann eine Oszillation in radialer Richtung der innerhalb des Rahmens beweglich gelagerten z-Masse.

Das dynamische Verhalten des Mikro-Gyroskops wird wesentlich verbessert, wenn die Kipp-Platten und die Rahmen mit Federn miteinander verbunden sind. Diese Federn wirken als Synchronisationsfedern und bewirken, dass die Primärbewegung, welche tangential um die z-Achse erfolgt, von den Kipp-Platten und den Rahmen gleichartig vollzogen wird. Hierdurch wird eine gemeinsame Schwingungsform der Kipp-Platten und der Rahmen realisiert, wobei alle beteiligten Massen mit gleicher Frequenz und gleicher Phase schwingen.

Vorzugsweise sind die Federn, welche die Kipp-Platten und die Rahmen miteinander verbinden, in tangentialer Richtung steif, in anderen Richtungen aber weich ausgebildet. Hierdurch ist es möglich, dass die Primärbewegung in den Kipp-Platten und in den Rahmen eine gemeinsame Schwingungsform mit gleicher Frequenz etabliert, jedoch die bei der Anzeige einer Drehrate in x- oder y-Richtung erfolgende Verkippung der Platten aus der x-y-Ebene heraus nicht durch die Synchronisationsfedern behindert wird. Die Kipp-Platten können hierdurch weitgehend unabhängig von den vorzugsweise in der x-y-Ebene verbleibenden Rahmen aus dieser herausbewegt werden, ohne dass ein großer Widerstand der Federn dem entgegenwirken würde.

Zum eindeutigen Anzeigen einer Drehrate um die x-Achse oder einer Drehrate um die y-Achse ist es vorteilhafterweise vorgesehen, dass einige der tangential um die z-Achse oszillierenden Massen bzw. Kipp-Platten um die x-Achse und andere dieser Massen bzw. Kipp-Platten nur um die y-Achse kippbar auf dem Substrat verankert sind. Die Massen bzw. Kipp-Platten, welche weiter von der x-Achse entfernt sind bzw. auf der y-Achse liegen und sich aus der x-y-Ebene herausbewegen, deuten hierdurch eine Drehrate um die y-Achse an. Andererseits deuten die Massen bzw. Kipp-Platten, welche weiter von der y-Achse entfernt sind bzw. auf der x-Achse liegen, bei ihrem Kippen um die y-Achse bzw. bei dem Herausbewegen aus der x-y-Achse eine Drehrate des Sensors um die x-Achse an.

Antriebselemente, welche die Primärschwingung einleiten, sind vorzugsweise an den nur tangential um die z-Achse oszillierenden Massen und/oder an den Rahmen angeordnet. Durch diese Antriebselemente wird als Primärschwingung eine Antriebsschwingung um die z-Achse in die entsprechenden Bauteile eingeleitet.

In einer vorteilhaften Ausbildung der Erfindung sind die zur Aufrechterhaltung der Antriebsschwingung um die z-Achse notwendigen Antriebselemente Elektroden von Kammkondensatoren, welche mit geeigneten Wechselantriebsspannungen beschickt werden. Teile der Antriebselemente sind hierzu an dem Substrat befestigt, andere Teile wiederum an den anzutreibenden Bauelementen. Durch das Anlegen der Wechselspannung werden die Elektroden wechselseitig angezogen, wodurch die oszillierende Primärschwingung der Bauteile erzeugt wird.

Sensorelemente sind vorzugsweise unterhalb der Kipp-Platten zum Erfassen der Auslenkung der Kipp-Platten angeordnet. Die Sensorelemente können beispielsweise Plattenkondensatoren sein, deren eine, bewegliche Hälfte durch eine Kipp-Platte und deren andere, statische Hälfte durch eine ausgedehnte Leiterbahn unterhalb der Kipp-Platte, auf der Oberfläche des Substrats, ausgebildet ist. Die Änderung der Kapazität im Zuge der Erfassung einer Messbewegung zieht dann eine entsprechende Änderung eines elektrischen Messsignals nach sich.

Vorzugsweise bilden die Sensorelemente, welche den z-Massen zugeordnet sind, bewegliche Messelektroden von Kondensatoren, deren statische Gegenstücke fest mit dem Substrat verbunden sind. Ein Teil der Messelektroden vollzieht somit die Bewegung der Sensorelemente mit und nähert sich oder entfernt sich hierbei von den statischen Gegenstücken der Messelektroden. Diese Abstandsänderung wird in ein veränderliches elektrisches Signal umgewandelt, welches Rückschlüsse auf die Drehrate des Sensors um die z-Achse erlaubt.

Die beweglichen Messelektroden der Sensorelemente sind vorzugsweise als in radialer Richtung bewegliche Rahmen ausgeführt. Es wird hierdurch ein stabiles Bauelement erhalten, welches die Bewegung zuverlässig signalisieren kann.

Besonders vorteilhaft ist es, wenn die z-Massen möglichst weit vom Zentrum des Sensors entfernt sind, da sie hierdurch einer stärkeren Corioliskraft ausgesetzt sind und somit eine größere Schwingungsamplitude an das zugeordnete Sensorelement abgeben. Bereits kleine Drehraten können hierdurch gemessen werden. Der Sensor kann darüber hinaus dennoch sehr kompakt und mit kleiner Fläche gebaut werden und eindeutige Signale für die jeweiligen Drehraten liefern.

Um zu gewährleisten, dass das Sensorelement von der tangentialen Bewegung der ihm zugeordneten z-Masse so weit als möglich entkoppelt wird, ist vorteilhafterweise vorgesehen, dass die z-Masse und das Sensorelement mittels einer in tangentialer Richtung weichen und in radialer Richtung steiferen Feder verbunden sind. Die radiale Bewegung der z-Masse überträgt sich hierdurch auf das Sensorelement, wobei beide Radialschwingungen gemeinsam die Sekundärbewegung ergeben, ohne dass die tangentiale Primärbewegung der z-Masse auf das Sensorelement durchkoppeln könnte.

Um das der z-Masse zugeordnete Sensorelement stabil zu lagern, insbesondere um es auch gegen Einflüsse in anderen als der vorgesehenen Richtung unempfindlich zu machen, ist vorgesehen, dass das Sensorelement mittels vorzugsweise vier Federn an dem Substrat befestigt ist. Die Federn sind dabei so ausgebildet, dass sie eine radiale Beweglichkeit des Sensorelementes ermöglichen, Bewegungen in anderen Richtungen allerdings zu verhindern versuchen.

Vorzugsweise ist die Kipp-Platte mittels Federn an dem Substrat angeordnet, wobei die Federn eine tangential-rotatorische Beweglichkeit der Kipp-Platte in der x-y-Ebene und eine Kippbeweglichkeit der Kipp-Platte aus der x-y-Ebene heraus erlauben. Die Federn sind hierzu vorzugsweise zentrumsnah an einem Anker fixiert.

Eine bevorzugte Ausbildung der Grundform des Sensors ist eine im Wesentlichen runde Außenform. Die Drehbewegung der Primärbewegung wird hierdurch unterstützt und darüber hinaus ist der Sensor auf sehr kleinem Bauraum unterzubringen.

Weitere Vorteile der Erfindung sind in nachfolgenden Ausführungsbeispielen beschrieben. Es zeigen:
- **Figur 1**: eine Draufsicht auf ein erfindungsgemäßes Gyroskop,
- **Figur 2**: eine Draufsicht auf Kipp-Platten des Gyroskops gemäß Figur 1,
- **Figur 3**: die Verbindung der Kipp-Platten gemäß Figur 2,
- **Figur 4**: eine Draufsicht auf die z-Sensoreinrichtung des Gyroskops der Figur 1,
- **Figur 5**: eine Detailansicht einer z-Sensoreinrichtung des Gyroskops gemäß Figur 1,
- **Figur 6**: eine Skizze der Primärbewegung des Sensors gemäß Figur 1,
- **Figur 7**: eine Sekundärbewegung zur Ermittlung einer y-Drehrate des Gyroskops gemäß Figur 1 und
- **Figur 8**: die Ermittlung einer z-Drehrate des Gyroskops gemäß Figur 1.

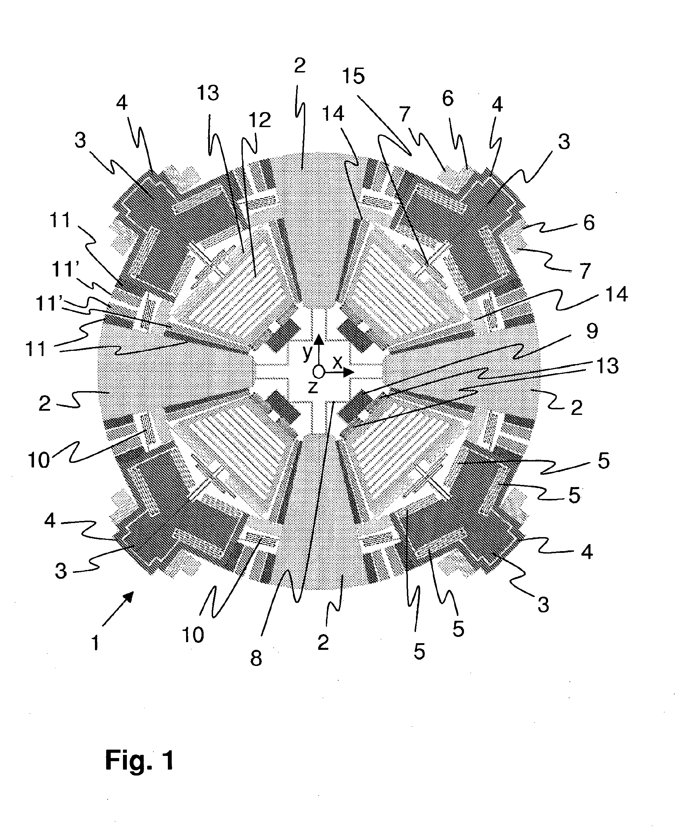

Figur 1 zeigt in der Draufsicht die Zusammenschau aller Komponenten eines mikro-elektromechanischen Gyroskops gemäß der vorliegenden Erfindung. In den nachfolgenden Figuren sind einzelne Komponenten, ebenso wie die Schwingungsformen des Gyroskops beim Erfassen von Drehraten, näher erläutert.

Das Gyroskop besteht insbesondere aus Elementen zur Erfassung einer Drehrate um die x-Achse und die y-Achse, wobei letztere in der Zeichenebene liegen. Weitere Baugruppen des Gyroskops in dieser Ebene betreffen die Detektion der z-Drehrate . Parallel zu und unterhalb dieser Ebene befindet sich ein Substrat, auf welchem die dargestellten Bauteile, wie nachfolgend beschrieben, angeordnet sind.

Zur Erfassung der x- und y-Drehraten sind Kipp-Platten 2 vorgesehen. Zur Ermittlung einer z-Drehrate, d.h. einer Drehung des Gyroskops um die z-Achse ist im Wesentlichen eine z-Masse 3 zwischen jeweils zwei Kipp-Platten 2 angeordnet. Die z-Masse 3 befindet sich in einem Rahmen 4 und ist in diesem mit vier Federn 5 befestigt. Der Rahmen 4 hängt über zwei Rahmenfedern 6 an zwei Rahmenankern 7, die auf dem Substrat fixiert sind.

Die Kipp-Platten 2 sind einerseits über Kippfedern 8 und einen Anker 9 auf dem Substrat befestigt. Außerdem sind die Kipp-Platten 2 mit zwei Synchronisationsfedern 10 jeweils zwischen zwei Rahmen 4 gehalten.

Als oszillierende Primärbewegung werden die Kipp-Platten 2 und die z-Massen 3 mit dem Rahmen 4 in eine oszillierende rotatorische Tangentialbewegung um die z-Achse angetrieben. Der Antrieb erfolgt in diesem Beispiel mittels Kammelektroden 11 und 11'. Hierbei sind Kammelektroden 11 an den bewegten Teilen, nämlich den Kipp-Platten 2 und dem Rahmen 4, befestigt, während die korrespondierenden Gegenelektroden 11' stationär auf dem Substrat befestigt sind. Durch das Anlegen einer Wechselspannung werden die Elektroden 11 und 11' jeweils auf entgegengesetzten Seiten wechselweise angezogen. Hierdurch entsteht die tangentiale Oszillation der Kipp-Platten 2 sowie der z-Massen 3 und Rahmen 4 im Sinne der Primärbewegung. Um die oszillierende Rotationsbewegung der einzelnen Elemente synchron zu halten und um die Kipp-Platten 2 und den Rahmen 4 stabil zu halten, sind die Synchronisationsfedern 10 zwischen den Kipp-Platten 2 und dem Rahmen 4 vorgesehen.

Tritt nun eine Drehung des Gyroskops um die x-Achse auf, so entstehen Corioliskräfte, welche bewirken, dass die auf der x-Achse angeordneten Kipp-Platten 2 aus der x-y-Ebene heraustreten. Aufgrund der vorbestimmten Elastizität der Kippfedern 8 sowie der Synchronisationsfedern 10 drehen sich die auf der x-Achse liegenden Kipp-Platten 2 um die y-Achse bzw. um die Kippfedern 8 in die Zeichenebene hinein und aus der Zeichenebene heraus. Hierfür sind die Kippfedern 8 derart ausgebildet, dass sie einerseits die Antriebsbewegung der Kipp-Platten 2 um die z-Achse erlauben und andererseits das Kippen um die y-Achse ebenfalls nicht wesentlich behindern. Um die x-Achse hingegen sind die Kippfedern 8 dieser auf der x-Achse befindlichen Kipp-Platten 2 weitgehend starr. Gleiches gilt für eine Drehrate des Gyroskops um die y-Achse. In diesem Falle kippen die auf der y-Achse befindlichen Kipp-Platten 2 aus der x-y-Ebene heraus und zeigen die entsprechende Corioliskraft, welche auf die Kipp-Platten 2 einwirkt, an. Die entsprechenden Kippfedern 8 dieser Kipp-Platten 2 sind analog zu den anderen Kippfedern ausgeführt. Sie erlauben aufgrund ihrer Anordnung und Ausbildung eine Drehbewegung der auf der y-Achse gelegenen Kipp-Platten 2 um die z-Achse sowie eine Kippbewegung um die x-Achse. Um die y-Achse hingegen sind sie weitgehend starr ausgebildet. Die Synchronisationsfedern 10 sind so ausgebildet, dass sie ebenfalls die Kippbewegung der Kipp-Platten 2 aus der Zeichenebene x, y heraus erlauben. Die tangentiale Bewegung um die z-Achse hingegen leiten sie an das benachbarte Bauteil weiter. Sie sind dementsprechend weitgehend steif ausgebildet für Kräfte, welche in tangentialer Richtung wirken.

Für die Anzeige einer z-Drehrate des Gyroskops dienen unter anderem die z-Masse 3 und der Rahmen 4. Die Primärbewegung vollzieht sich zusammen mit den Kipp-Platten 2 ebenfalls in tangentialer Richtung um die z-Achse. Der Antrieb erfolgt mit Kammelektroden 11 und 11', wobei die Kammelektroden 11 an dem Rahmen 4 angeordnet sind, während die Kammelektroden 11' stationär auf dem Substrat befestigt sind. Die tangentiale Bewegung um die z-Achse wird unterstützt durch die Rahmenfedern 6, welche die tangentiale Bewegung erlauben, eine radiale Bewegung des Rahmens 4 jedoch weitgehend durch die entsprechende Federsteifigkeit in dieser Richtung verhindern.

Aufgrund der tangentialen Primärbewegung entstehen Corioliskräfte in radialer Richtung, sobald das Gyroskop um die z-Achse dreht. Der Rahmen 4 kann durch die Aufhängung an den Rahmenfedern 6 und den Synchronisationsfedern 10 nicht in radialer Richtung ausweichen. Die z-Masse 3 hingegen ist in dem Rahmen 4 mit ihren Federn 5 so aufgehängt, dass sie in radialer Richtung der Corioliskraft nachgeben kann. Die Federn 5, mit welchen die z-Masse 3 in dem Rahmen 4 befestigt ist, sind derart zueinander angestellt, dass die z-Masse 3 unempfindlicher gegen parasitäre Drehmomente wird, welche allein aus der tangentialen Primärbewegung entstehen. Die z-Masse 3 reagiert hierdurch im Wesentlichen nur auf Corioliskräfte, die durch eine Drehrate entlang der z-Achse entstehen.

Um die z-Drehrate frei von Störeinflüssen feststellen zu können, ist die z-Masse 3 mit einem Sensorelement 12 verbunden. Das Sensorelement 12 ist mittels Sensorfedern 13 an dem Anker 9 sowie an zwei Ankern 14 befestigt. Das Sensorelement 12 ist darüber hinaus mit der z-Masse 3 über eine Koppelfeder 15 verbunden. Die Koppelfeder 15 ist in tangentialer Richtung weich und in radialer Richtung steifer ausgebildet. Hierdurch entsteht eine Entkopplung zwischen der Antriebsbewegung der z-Masse in tangentialer Richtung und der Sensor- bzw. Sekundärbewegung in radialer Richtung. Während die z-Masse in tangentialer Richtung angetrieben wird, ohne dass dies wesentliche Auswirkungen auf das Sensorelement 12 hat, wird beim Auftreten einer Corioliskraft die z-Masse 3 in radialer Richtung nach außen und innen bewegt und nimmt bei dieser Bewegung das Sensorelement 12 aufgrund der entsprechenden Federsteifigkeit der Koppelfeder 15 mit. Die Sensorfedern 13 sind bzgl. ihrer Federsteifigkeit ebenfalls so ausgebildet, dass sie das Sensorelement 12 in radialer Richtung kaum behindern, d.h. dass sie in dieser Richtung eine relative geringe und jedenfalls genau einstellbare Federsteifigkeit aufweisen, während sie Bewegungen des Sensorelements 12 in tangentialer Richtung weitgehend verhindern. Es entsteht hierdurch eine Entkopplung der Primärbewegung von der Sekundärbewegung, so dass das Sensorelement 12 eine auftretende Corioliskraft in radialer Richtung nur durch eine entsprechende oszillierende Bewegung in radialer Richtung anzeigt. Die Gitterstruktur des Sensorelementes 12 realisiert hierbei die bewegliche Elektrode eines Kondensators, dessen statische Gegenpole innerhalb der Ausnehmungen auf dem Substrat fixiert und nicht mitgezeichnet sind. Diese variable Kapazität dient zur Umwandlung der Erfassungsbewegung in ein elektrisches Signal.

Einzelne Elemente des Gyroskops sind in folgenden Figuren der besseren Übersichtlichkeit halber herausgelöst aus den übrigen Bauelementen dargestellt.

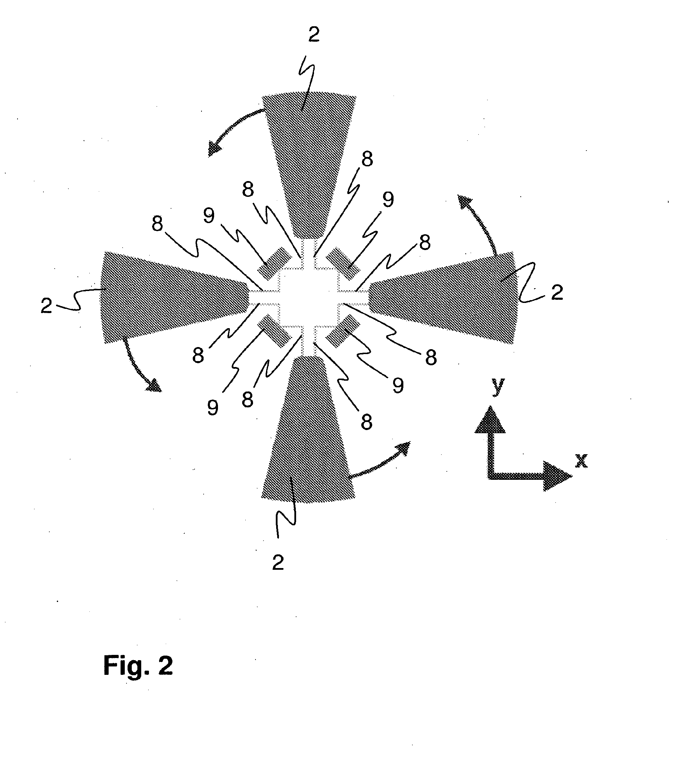

Figur 2 zeigt die Kipp-Platten 2. Jede der Kipp-Platten 2 ist mittels zweier Kippfedern 8 an zwei Ankern 9 befestigt. Die Kippfedern 8 erlauben einerseits die tangentiale oszillierende Primärbewegung der Kipp-Platten 2, andererseits erlauben sie auch die Verkippung der Kipp-Platten 2 aus der x-y-Ebene heraus um die Kippfedern 8 herum. In radialer Richtung sind die Kippfedern 8 hingegen steif ausgebildet, so dass die Kipp-Platten 2 nicht nennenswert auf eine Corioliskraft, welche in radialer Richtung wirkt und eine z-Rotation des Gyroskops anzeigt, ausgelenkt werden. Eine vorbestimmte Auslenkung der Kipp-Platten 2 erfolgt somit aufgrund einer Drehrate um die x- oder um die y-Achse.

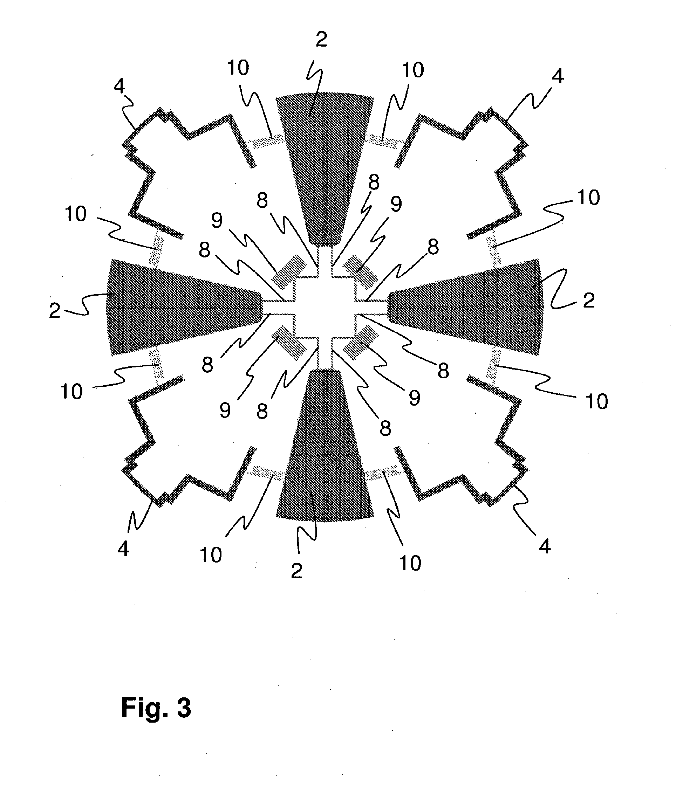

Gemäß Figur 3 sind die Kipp-Platten 2 der Figur 2 mit Rahmen 4 und Synchronisationsfedern 10 verbunden. Diese hier dargestellte Einheit wird in eine synchrone tangentiale Bewegung um die z-Achse als Primärbewegung versetzt. Die Verbindungsfedern 10 synchronisieren die tangentiale Bewegung der Kipp-Platten 2 und der Rahmen 4. Geschwindigkeitsunterschiede in den Komponenten, welche evtl. durch Toleranzen bei der Fertigung des Gyroskops entstehen könnten, werden durch die Synchronisationsfedern 10 ausgeglichen. Die einzelnen Bauteile schwingen somit mit einer gemeinsamen Resonanzfrequenz und zeigen dementsprechend auch in gleicher Weise Drehraten an.

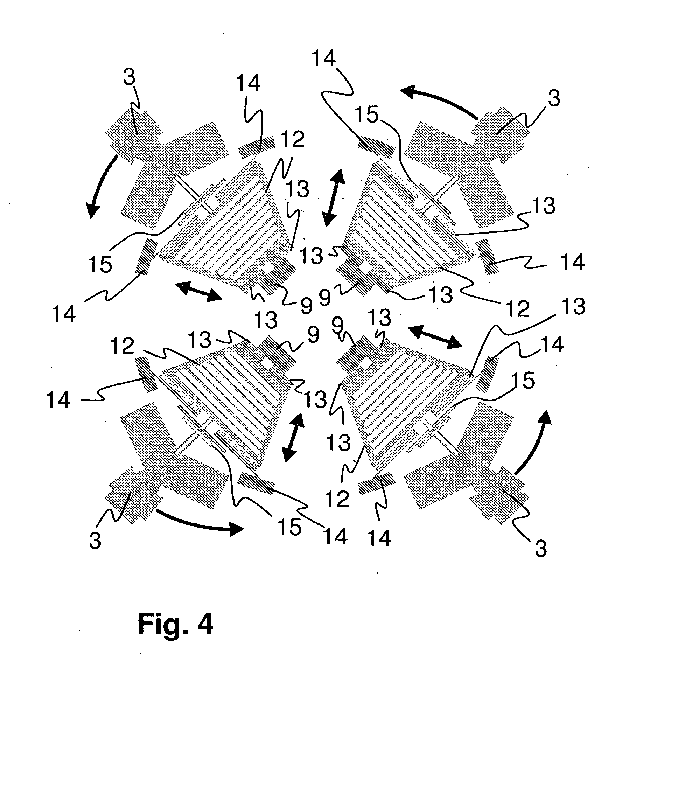

Figur 4 zeigt die Bauteile, welche für die Erfassung einer z-Drehrate maßgeblich sind. In der Primärbewegung wird die z-Masse 3 zusammen mit dem hier nicht dargestellten Rahmen 4 in eine oszillierende tangentiale Bewegung um die z-Achse versetzt. Als Reaktion auf eine Rotation des Gyroskops um die z-Achse wird die z-Masse 3 zu radialer Oszillation angeregt. Die z-Masse 3 ist über die Koppelfeder 15 mit dem Sensorelement 12 verbunden. Das Sensorelement 12 ist über Sensorfedern 13 an den Ankern 9 und 14 fixiert. Die Sensorfedern 13 erlauben eine radiale Bewegung des Sensorelementes 12, welche im Zuge der Erfassung einer Drehrate um die z-Achse durch die radiale Oszillation der z-Masse 3 eingekoppelt wird. Die Übertragung der radialen Bewegung von der z-Masse 3 auf das Sensorelement 12 erfolgt durch die Koppelfeder 15. Diese ist einerseits weich genug, um die tangentiale Primärbewegung der z-Masse 3 nicht auf das Sensorelement 12 zu übertragen und andererseits so steif, dass die Sekundärbewegung der z-Masse 3 zu einer Radialbewegung des Sensorelementes 12 führt. Vier der entsprechenden Bauteile sind im 90°-Winkel zueinander auf dem Substrat des Gyroskops angeordnet. Sie befinden sich dabei auf den Winkelhalbierenden zwischen der x- und der y-Achse.

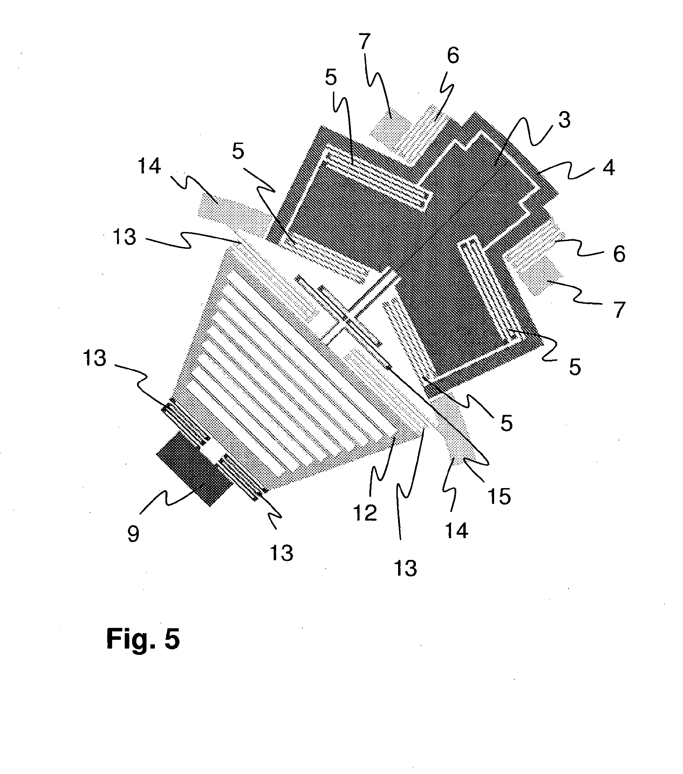

In Figur 5 ist nochmals eine Detailansicht der Bauelemente für die Ermittlung der z-Drehrate dargestellt. Die z-Masse 3 ist mittels Federn 5 in dem Rahmen 4 befestigt. Der Rahmen 4 ist über die in tangentialer Richtung weichen Rahmenfedern 6 an dem Rahmenanker 7 befestigt. Das Sensorelement 12 ist neben der Befestigung an dem Anker 9 zusätzlich an den Ankern 14 angeordnet. Die Anker 14 können zusätzlich zu ihrer Funktion als Fixierungspunkte für Federn 13 als Stopper für die Primärbewegung des Rahmens 4 und auch der Kipp-Platten 2 dienen. Die radiale Bewegung der z-Masse 3 wird über die Koppelfeder 15 auf das Sensorelement 12 übertragen, welches ebenfalls zusammen mit der z-Masse 3 in eine radiale oszillierende Bewegung gerät, sobald eine Corioliskraft eine z-Drehrate anzeigt.

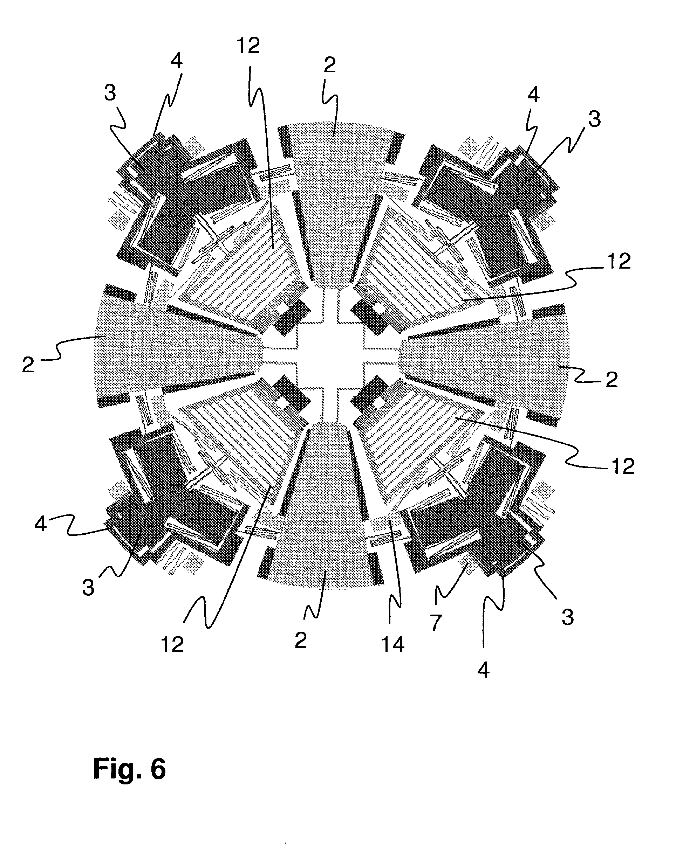

Figur 6 zeigt das Gyroskop in seiner Primärbewegung in schematischer Darstellung. Daraus wird ersichtlich, dass die Kipp-Platten 2 ebenso wie die Rahmen 4 mit den z-Massen 3 in eine oszillierende Drehbewegung um die z-Achse versetzt werden. Die Anker 14 dienen dabei als Stopper der Kipp-Platten 2 und der Rahmen 4. Die Sensorelemente 12 bleiben bei dieser Primärbewegung unbewegt auf dem Substrat angeordnet. Die Darstellung ist ebenso wie in den folgenden Figuren schematisch, weshalb im Detail Ungenauigkeiten bei der Darstellung vorhanden sein können.

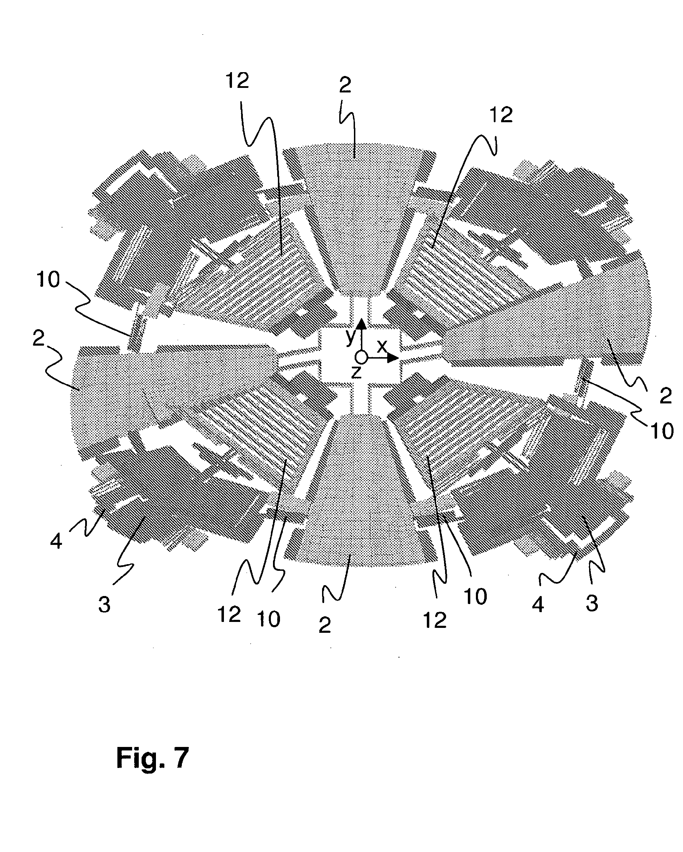

In Figur 7 ist das Auslenken der auf der x-Achse befindlichen Kipp-Platten 2 dargestellt, welches eine x-Drehrate des Gyroskops anzeigt. Die auf der x-Achse befindlichen Kipp-Platten 2 werden um die Kippfedern 8, mit welchen sie an den Ankern 9 befestigt sind, aus der x-y-Ebene herausgekippt. Die auf der y-Achse befindlichen Kippelemente 2 bleiben hingegen in dieser Ebene. Durch die Federsteifigkeiten der Synchronisationsfedern 10 werden bei diesem Ausführungsbeispiel auch die Rahmen 4 und die z-Massen 3 gekippt, jedoch schlagen diese Auslenkungen aufgrund der Weichheit der Koppelfedern 15 nicht auf das Sensorelement 12 durch. Durch Plattenkondensatoren, deren bewegliche Hälfte durch die Kipp-Platte 2 selbst gebildet wird, und deren statische Hälfte sich unterhalb der zugeordneten Kipp-Platte 2 auf dem Substrat befindet, können die jeweiligen Kippbewegungen in ein elektrisches Signal umgewandelt werden. Aufgrund der Weichheit der Koppelfedern 15 haben diese Bewegungen keine Auswirkung auf die Sensorelemente 12. In gleicher Weise ist eine y-Drehrate zu erfassen. Dabei kippen die Kipp-Platten 2, welche entlang der y-Achse angeordnet sind, aus der x-y-Ebene heraus. Gegebenenfalls werden hierdurch die z-Massen 3 und die Rahmen 4, welche an den Kipp-Platten 2 über die Synchronisationsfedern 10 befestigt sind, ebenfalls aus der x-y-Ebene zumindest teilweise herausbewegt.

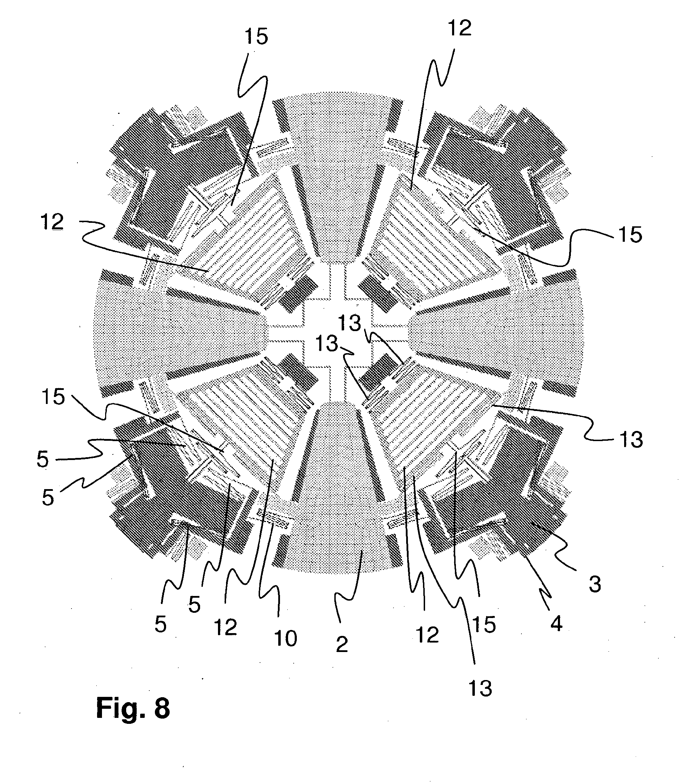

In Figur 8 ist die Erfassung einer z-Drehrate des Gyroskops schematisch dargestellt. Hierbei werden, wie bereits zuvor beschrieben, die z-Massen 3 in radialer Richtung durch die auftretende Corioliskraft in radiale Schwingungen versetzt. Durch die Koppelfeder 15 wird bei dieser Bewegung der z-Masse 3 das Sensorelement 12 ebenfalls radial oszillierend bewegt. Die entsprechenden Federn sind so ausgelegt, dass das Sensorelement 12 in dieser radialen Richtung leicht bewegbar ist, hingegen in einer Richtung aus der x-y-Ebene heraus oder in tangentialer Richtung um die z-Achse herum unbeweglich bleibt. Die radiale Bewegung des Sensorelementes 12 kann an der Gitterstruktur des Sensorelementes mittels korrespondierender Elektroden, welche an dem Substrat stationär befestigt sind, ermittelt werden. Zur Erfassung der z-Drehrate bleiben die Kipp-Platten 2 ebenso wie der Rahmen 4 weitgehend unbewegt. Gegebenenfalls kann jedoch, abhängig von den entsprechenden Federkonstanten, der Rahmen 4 leicht in radialer Richtung ausgelenkt werden.

Die vorliegende Erfindung ist nicht auf die dargestellte Ausführungsbeispiele beschränkt. Insbesondere sind Abwandlungen, beispielsweise der Gestaltung der einzelnen Bauteile sowie auch die Anordnung der Bauteile zueinander anders als hier dargestellt möglich, soweit sie im Rahmen der geltenden Patentansprüche sind.

### Bezugszeichenliste

- 1: Substrat
- 2: Kipp-Platte
- 3: z-Masse
- 4: Rahmen
- 5: Feder
- 6: Rahmenfeder
- 7: Rahmenanker
- 8: Kippfeder
- 9: Anker
- 10: Synchronisationsfeder
- 11: Kammelektrode
- 11': Gegenelektrode
- 12: Sensorelement
- 13: Sensorfeder
- 14: Anker
- 15: Koppelfeder

## Patentansprüche

1. Mikro-Gyroskop zur Ermittlung von Rotationsbewegungen um drei senkrecht aufeinanderstehende Raumachsen x, y und z,
- mit einem Substrat (1), auf welchem mehrere tangential um die senkrecht auf dem Substrat (1) stehende z-Achse oszillierende Massen (2, 3) angeordnet sind, wobei die oszillierenden Massen (2, 3) mittels Federn (5, 6, 8) und Ankern (7, 9) auf dem Substrat (1) befestigt sind,
- mit Antriebselementen (11) zur Aufrechterhaltung oszillierender tangentialer Schwingungen der Massen (2, 3) um die z-Achse, wodurch die Massen (2, 3) bei einer Rotation des Substrats (1) um eine beliebige Raumachse Corioliskräften und dadurch verursachten Auslenkungen unterworfen sind und
- mit Sensorelementen, um die Auslenkungen der Massen (2, 3) aufgrund der erzeugten Corioliskräfte zu erfassen,
wobei
- einige der um die z-Achse oszillierenden Massen (2, 3) im Wesentlichen um die parallel zum Substrat (1) verlaufende x-Achse kippbar gelagert sind,
- andere der um die z-Achse oszillierenden Massen (2, 3) im Wesentlichen um die ebenfalls parallel zum Substrat (1) verlaufende y-Achse kippbar gelagert sind,
- wiederum wenigstens eine andere der oszillierenden Massen (2, 3) zumindest teilweise zusätzlich im Wesentlichen radial zur z-Achse in der x-y-Ebene parallel zur Ebene des Substrats (1) auslenkbar ist, **dadurch gekennzeichnet,**
- **dass** diese wenigstens eine zusätzlich radial auslenkbare z-Masse (3) jeweils mittels einer Feder (15) mit jeweils einem ebenfalls radial zu der z-Achse auslenkbaren, aber nicht um die z-Achse oszillierenden Sensorelement (12) zum Erfassen ihrer durch Corioliskräfte hervorgerufenen radialen Auslenkung verbunden ist.

2. Mikro-Gyroskop nach Anspruch 1, **dadurch gekennzeichnet, dass** das Gyroskop im Wesentlichen acht Massen (2, 3) aufweist, welche tangential um die z-Achse oszillieren, wobei vier dieser Massen als z-Masse (3) konzipiert sind, welche zusätzlich radial zur z-Achse beweglich ist.

3. Mikro-Gyroskop nach einem oder mehreren der vorherigen Ansprüche, **dadurch gekennzeichnet, dass** die im Wesentlichen nur tangential um die z-Achse oszillierenden Massen Kipp-Platten (2) zum Erfassen einer Drehung des Substrats (1) um die x- bzw. y-Achse sind.

4. Mikro-Gyroskop nach einem oder mehreren der vorherigen Ansprüche, **dadurch gekennzeichnet, dass** die wenigstens eine sowohl radial zur als auch tangential um die z-Achse bewegliche z-Masse (3) an jeweils einen Rahmen (4) gekoppelt ist, um in tangentiale Bewegung um die z-Achse versetzt zu werden.

5. Mikro-Gyroskop nach Anspruch 4, **dadurch gekennzeichnet, dass** der Rahmen (4) mit Federn (6), insbesondere mit zwei Federn (6) tangential um die z-Achse beweglich auf dem Substrat (1) verankert ist.

6. Mikro-Gyroskop nach Anspruch 3, **dadurch gekennzeichnet, dass** Rahmen (4) zwischen den mehreren nur tangential um die z-Achse oszillierenden Massen bzw. Kipp-Platten (2) angeordnet sind.

7. Mikro-Gyroskop nach Anspruch 4, **dadurch gekennzeichnet, dass** die sowohl radial zur als auch tangential um die z-Achse bewegliche z-Masse (3) mit dem Rahmen (4) mit mindestens einer, vorzugsweise vier Feder/n (5) verbunden ist.

8. Mikro-Gyroskop nach Anspruch 4, **dadurch gekennzeichnet, dass** die z-Masse (3) in dem Rahmen (4) im Wesentlichen nur radial beweglich angeordnet ist.

9. Mikro-Gyroskop nach Anspruch 4, **dadurch gekennzeichnet, dass** der Rahmen (4) im Wesentlichen nur tangential um die z-Achse beweglich auf dem Substrat (1) verankert sind.

10. Mikro-Gyroskop nach den Ansprüchen 3 und 4, **dadurch gekennzeichnet, dass** die Kipp-Platten (2) und der Rahmen (4) mit in tangentialer Richtung steifen, in radialer Richtung aber weichen Federn (10) miteinander verbunden sind.

11. Mikro-Gyroskop nach Anspruch 3, **dadurch gekennzeichnet, dass** einige der nur tangential um die z-Achse oszillierenden Massen bzw. Kipp-Platten (2) im Wesentlichen nur um die x-Achse und andere der nur tangential um die z-Achse oszillierenden Massen bzw. Kipp-Platten (2) im Wesentlichen nur um die y-Achse kippbar auf dem Substrat (1) verankert sind.

12. Mikro-Gyroskop nach einem oder mehreren der vorherigen Ansprüche, **dadurch gekennzeichnet, dass** die nur tangential um die z-Achse oszillierenden Massen (2) und/oder die Rahmen (4) Antriebselemente (11) zur Aufrechterhaltung der tangentialen Antriebsschwingung um die z-Achse enthalten.

13. Mikro-Gyroskop nach Anspruch 12, **dadurch gekennzeichnet, dass** die zur Aufrechterhaltung der Antriebsschwingung um die z-Achse notwendigen Antriebselemente (11) Elektroden von Kammkondensatoren sind, welche mit geeigneten Wechsel-Antriebsspannungen beschickt werden.

14. Mikro-Gyroskop nach einem oder mehreren der vorherigen Ansprüche, **dadurch gekennzeichnet, dass** das der wenigstens einen z-Masse (3) zur Erfassung ihrer durch Corioliskräfte verursachten radialen Auslenkungen zugeordnete Sensorelement (12) bewegliche Messelektroden von Kondensatoren umfasst, deren statische Gegenstücke fest mit dem Substrat (1) verbunden sind.

15. Mikro-Gyroskop nach Anspruch 14, **dadurch gekennzeichnet, dass** die beweglichen Messelektroden als in radialer Richtung bewegliche Rahmen ausgeführt sind.

16. Mikro-Gyroskop nach Anspruch 14,
**dadurch gekennzeichnet, dass** die Messelektroden des Sensorelements (12) dem Zentrum des Sensors näher sind als die wenigstens eine z-Masse (3).

17. Mikro-Gyroskop nach einem oder mehreren der vorherigen Ansprüche, **dadurch gekennzeichnet, dass** die z-Masse (3) und das Sensorelement (12) mittels einer in tangentialer Richtung weichen und in radialer Richtung steiferen Feder (15) verbunden sind.

18. Mikro-Gyroskop nach einem oder mehreren der vorherigen Ansprüche, **dadurch gekennzeichnet, dass** das Sensorelement (12) mittels vorzugsweise vier Federn (13) an dem Substrat (1) befestigt ist.

19. Mikro-Gyroskop nach Anspruch 3, dadurch gekenntzeichnet, dass die Kipp-Platten (2) mittels Federn (8) an dem Substrat (1) angeordnet sind, welche eine tangentiale Beweglichkeit in der x-y-Ebene und eine Kippbeweglichkeit aus der x-y-Ebene heraus erlauben, aber eine torsionale Verdrehung der Kipp-Platten (2) um ihre Längsachsen erschweren.

## Claims

1. Microgyroscope for determining rotational movements about three perpendicularly stacked spatial axes x, y and z,
- with a substrate (1) on which several masses (2, 3) are arranged tangentially oscillating about the z axis that is perpendicularly positioned on the substrate (1), wherein the oscillating masses (2, 3) are fastened to the substrate (1) with springs (5, 6, 8) and tie bolts (7, 9),
- with drive elements (11) for maintaining the oscillating tangential vibrations of the masses (2, 3) about the z axis, as a result of which the masses (2, 3) are subject to Coriolis forces and the deflections caused by them when the substrate (1) rotates around any spatial axis, and
- with sensor elements for registering the deflection of the masses (2, 3) owing to the generated Coriolis forces,
wherein
- some of the masses (2, 3) oscillating about the z axis are essentially tiltably arranged about the x axis that runs parallel to the substrate (1),
- other masses (2, 3) oscillating about the z axis are essentially tiltably arranged about the y axis that runs parallel to the substrate (1),
- in turn, at least one other of the oscillating masses (2, 3) can be additionally be deflected at least in part essentially radially with respect to the z axis in the x-y plane parallel to the plane of the substrate (1),
**characterized in**
- **that** each of this at least one z mass (3) that can be additionally deflected radially is connected with a spring (15) to an oscillating sensor element (12) that can also be deflected radially with regard to the z axis but is not oscillating about the z axis for registering the radial deflection caused by Coriolis forces.

2. Microgyroscope according to claim 1 **characterized in that** the gyroscope essentially comprises eight masses (2, 3) that oscillate tangentially about the z axis, in which case four of these masses are conceived as a z mass (3) that can additionally be moved radially with respect to the z axis.

3. Microgyroscope according to one or several of the previous claims **characterized in that** the masses oscillating essentially only tangentially about the z axis are tilting plates (2) for registering a rotation of the substrate (1) about the x or y axis.

4. Microgyroscope according to one or several of the previous claims **characterized in that** each of the at least one z mass (3) that can be moved both radially to and tangentially about the z axis is coupled to a frame (4) so it can be set in tangential motion about the z axis.

5. Microgyroscope according to claim 4 **characterized in that** the frame (4) is anchored on the substrate (1) with springs (6), especially with two springs (6) and can be moved tangentially about the z axis.

6. Microgyroscope according to claim 3 **characterized in that** frames (4) are arranged between the several masses or tilting plates (2) oscillating only tangentially about the z axis.

7. Microgyroscope according to claim 4 **characterized in that** the z mass (3) that can be moved both radially to and tangentially about the z axis is connected with the frame (4) with at least one, preferably four, spring(s) (5).

8. Microgyroscope according to claim 4 **characterized in that** the z mass (3) is arranged in the frame (4) in a way that it can be moved essentially only radially.

9. Microgyroscope according to claim 4 **characterized in that** the frame (4) is anchored to the substrate (1) in a way that it can be moved essentially only tangentially about the z axis.

10. Microgyroscope according to claims 3 and 4 **characterized in that** the tilting plates (2) and the frame (4) are connected to one another with springs (10) stiff in tangential direction, but soft in radial direction.

11. Microgyroscope according to claim 3 **characterized in that** some of the masses or tilting plates (2) oscillating only tangentially about the z axis are anchored on the substrate (1) so that they can be tilted essentially only about the x axis and other masses or tilting plates (2) oscillating only tangentially about the z axis are anchored on the substrate (1) so that they can be tilted essentially only about the y axis.

12. Microgyroscope according to one or several of the previous claims **characterized in that** the masses (2) oscillating only tangentially about the z axis and/or the frames (4) contain drive elements (11) for maintaining the tangential drive oscillation about the z axis.

13. Microgyroscope according to claim 12 **characterized in that** the drive elements (11) needed for maintaining the drive oscillation about the z axis are electrodes of comb capacitors supplied with suitable AC drive voltages.

14. Microgyroscope according to one or several of the previous claims **characterized in that** the sensor element (12) allocated to the at least one z mass (3) for registering its radial deflections caused by the Coriolis forces comprise movable measuring electrodes of capacitors whose static counterparts are fixedly connected to the substrate (1).

15. Microgyroscope according to claim 14 **characterized in that** the movable measuring electrodes are executed as frames movable in radial direction.

16. Microgyroscope according to one claim 14 **characterized in that** the measuring electrodes of the sensor element (12) are closer to the center of the sensor than the at least one z mass (3).

17. Microgyroscope according to one or several of the previous claims **characterized in that** the z mass (3) and the sensor element (12) are linked with a spring (15) that is soft in tangential direction and stiffer in radial direction.

18. Microgyroscope according to one or several of the previous claims **characterized in that** the sensor element (12) is fastened to the substrate (1) by means of preferably four springs (13).

19. Microgyroscope according to claim 3 **characterized in that** the tilting plates (2) are arranged on the substrate (1) by means of springs (8) which allow a tangential movement in the x-y plane and a tilting movement out of the x-y plane, but make a torsional bending of the tilting plates (2) about their longitudinal axes harder.

## Revendications

1. Micro-gyroscope pour déterminer des mouvements de rotation autour de trois axes spatiaux x, y et z disposés verticalement l'un au-dessus de l'autre.
- avec un substrat (1), sur lequel sont disposées plusieurs masses (2, 3) oscillant tangentiellement autour de l'axe z disposée verticalement sur le substrat (1), sachant que les masses oscillantes (2, 3) sont fixées sur le substrat (1) au moyen de ressorts (5, 6, 8) et d'ancres (7, 9),
- avec des éléments d'entraînement (11) pour maintenir des vibrations oscillantes tangentielles des masses (2, 3) autour de l'axe z, faisant à ce que les masses (2, 3), lors d'une rotation du substrat (1) autour d'un quelconque axe spatial, soient soumises à des forces de Coriolis et, ainsi, à des déviations provoquées par ces dernières, et
- avec des éléments capteurs pour capter les déviations des masses (2, 3) en raison des forces de Coriolis générées, dans lequel
- quelques-unes des masses (2, 3) oscillant autour de l'axe z sont montées de manière essentiellement basculante autour de l'axe x s'allongeant parallèlement au substrat (1),
- d'autres parmi les masses (2, 3) oscillant autour de l'axe z sont montées de manière essentiellement basculante autour de l'axe y s'allongeant également parallèlement au substrat (1),
- au moins une autre des masses oscillantes (2, 3), pour sa part, peut de surcroît être déviée au moins partiellement de manière essentiellement radiale à l'axe z, dans le plan x-y et parallèlement au plan du substrat (1),
**caractérisé en ce que**
- cette au moins une masse z (3) pouvant de surcroît être déviée radialement est reliée respectivement à un ressort (15) avec respectivement un élément capteur (12) également déviable radialement par rapport à l'axe z, mais n'oscillant pas autour de l'axe z, pour capter sa déviation radiale provoquée par des forces de Coriolis.

2. Micro-gyroscope selon la revendication 1, **caractérisé en ce que** le gyroscope présente essentiellement huit masses (2, 3), qui oscillent tangentiellement autour de l'axe z, sachant que quatre de ces masses sont conçues sous la forme de masse z (3), qui sont de surcroît mobiles radialement par rapport à l'axe z.

3. Micro-gyroscope selon l'une ou plusieurs des revendications précédentes, **caractérisé en ce que** les masses oscillant pour l'essentiel seulement de manière tangentielle autour de l'axe z sont des plaques basculantes (2) pour capter une rotation du substrat (1) autour de l'axe x ou y.

4. Micro-gyroscope selon l'une plusieurs des revendications précédentes, **caractérisé en ce que** l'au moins une masse z (3), mobile tant radialement que tangentiellement autour de l'axe z, est couplée respectivement à un cadre (4) pour être mise en mouvement tangentiel autour de l'axe z.

5. Micro-gyroscope selon la revendication 4, **caractérisé en ce que** le cadre (4) est ancré par des ressorts (6), en particulier par deux ressorts (6), sur le substrat (1) de manière tangentiellement mobile autour de l'axe z.

6. Micro-gyroscope selon la revendication 3, **caractérisé en ce que** des cadres (4) sont disposés entre les plusieurs masses ou plaques basculantes (2) oscillant seulement de manière tangentielle autour de l'axe z.

7. Micro-gyroscope selon la revendication 4, **caractérisé en ce que** la masse z (3) mobile tant radialement que tangentiellement autour de l'axe z est reliée au cadre (4) par au moins un, de préférence quatre ressort(s) (5).

8. Micro-gyroscope selon la revendication 4, **caractérisé en ce que** la masse z (3) est disposée dans le cadre (4) de manière, pour l'essentiel, mobile seulement radialement.

9. Micro-gyroscope selon la revendication 4, **caractérisé en ce que** le cadre (4) est ancré sur le substrat (1) de manière, pour l'essentiel, mobile seulement tangentiellement autour de l'axe z.

10. Micro-gyroscope selon les revendications 3 et 4, **caractérisé en ce que** les plaques basculantes (2) et le cadre (4) sont reliés les uns aux autres par des ressorts (10) rigides dans le sens tangentiel, mais mous dans le sens radial.

11. Micro-gyroscope selon la revendication 3, **caractérisé en ce que** quelques-unes des masses ou plaques basculantes (2) oscillant seulement tangentiellement autour de l'axe z sont ancrées sur le substrat (1) de manière basculante pour l'essentiel seulement autour de l'axe x et d'autres des masses ou plaques basculantes (2) oscillant seulement tangentiellement autour de l'axe z sont ancrées sur le substrat (1) de manière basculante pour l'essentiel seulement autour de l'axe y.

12. Micro-gyroscope selon l'une ou plusieurs des revendications précédentes, **caractérisé en ce que** les masses (2) oscillant seulement de manière tangentielle autour de l'axe z et/ou les cadres (4) comportent des éléments d'entraînement (11) pour maintenir l'oscillation d'entraînement tangentielle autour de l'axe z.

13. Micro-gyroscope selon la revendication 12, **caractérisé en ce que** les éléments d'entraînement (11) nécessaires pour maintenir l'oscillation d'entraînement autour de l'axe z sont des électrodes de condensateurs à peigne, qui sont soumises à des tensions alternatives d'entraînement appropriées.

14. Micro-gyroscope selon l'une ou plusieurs des revendications précédentes, **caractérisé en ce que** l'élément capteur (12) attribué à l'au moins une masse z (3) pour capter ses déviations radiales induites par les forces de Coriolis comprend des électrodes de mesure mobiles de condensateurs, dont les composants complémentaires sont rigidement reliés au substrat (1).

15. Micro-gyroscope selon la revendication 14, **caractérisé en ce que** les électrodes de mesure mobiles se présentent sous la forme de cadres mobiles dans le sens radial.

16. Micro-gyroscope selon la revendication 14, **caractérisé en ce que** les électrodes de mesure de l'élément capteur (12) sont plus proches du centre du capteur que l'au moins une masse z (3).

17. Micro-gyroscope selon l'une ou plusieurs des revendications précédentes **caractérisé en ce que** la masse z (3) et l'élément capteur (12) sont reliés par un ressort (15) mou dans le sens tangentiel et plus rigide dans le sens radial.

18. Micro-gyroscope selon l'une ou plusieurs des revendications précédentes **caractérisé en ce que** l'élément capteur (12) est fixé sur le substrat (1) de préférence au moyen de quatre ressorts (13).

19. Micro-gyroscope selon la revendication 3, **caractérisé en ce que** les plaques basculantes (2) sont disposées sur le substrat (1) à l'aide de ressorts (8), qui permettent une mobilité tangentielle dans le plan x-y et une mobilité en basculement depuis le plan x-y, mais rendent plus difficile un gauchissement torsionnel des plaques basculantes (2) sur leurs axes longitudinaux.
